(19) Europäisches Patentamt
European Patent Office
Office européen des brevets

(11) EP 4 029 690 B1

(12) EUROPEAN PATENT SPECIFICATION

(45) Date of publication and mention of the grant of the patent:
**22.04.2026 Bulletin 2026/17**

(21) Application number: **20862910.5**

(22) Date of filing: **10.09.2020**

(51) International Patent Classification (IPC):
***B32B 15/08*** (2006.01) ***B32B 15/088*** (2006.01)
***B32B 7/025*** (2019.01) ***B32B 5/14*** (2006.01)
***B32B 7/12*** (2006.01) ***B32B 15/18*** (2006.01)
***B32B 27/08*** (2006.01) ***B32B 27/20*** (2006.01)
***B32B 27/28*** (2006.01)

(52) Cooperative Patent Classification (CPC):
**B32B 5/145; B32B 7/12; B32B 15/08; B32B 15/18; B32B 27/08; B32B 27/20; B32B 27/205; B32B 27/22; B32B 27/281; H05K 1/0393; H05K 3/381; H10K 77/111;** B32B 2250/02; B32B 2250/03; B32B 2255/06; (Cont.)

(86) International application number:
**PCT/JP2020/034215**

(87) International publication number:
**WO 2021/049556 (18.03.2021 Gazette 2021/11)**

# (54) METAL-CLAD LAMINATE FOR FLEXIBLE ELECTRONIC DEVICES, AND FLEXIBLE ELECTRONIC DEVICE USING SAME

METALLKASCHIERTES LAMINAT FÜR FLEXIBLE ELEKTRONISCHE VORRICHTUNGEN UND FLEXIBLE ELEKTRONISCHE VORRICHTUNG DAMIT

STRATIFIÉ À REVÊTEMENT MÉTALLIQUE POUR DISPOSITIFS ÉLECTRONIQUES FLEXIBLES, ET DISPOSITIF ÉLECTRONIQUE FLEXIBLE L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.09.2019 JP 2019165629**

(43) Date of publication of application:
**20.07.2022 Bulletin 2022/29**

(73) Proprietor: **NIPPON STEEL Chemical & Material Co., Ltd.**
**Tokyo 103-0027 (JP)**

(72) Inventors:
- **WANG, Hongyuan**
  **Tokyo 103-0027 (JP)**
- **NAKATSUKA, Jun**
  **Tokyo 103-0027 (JP)**
- **IWASAKI, Toshio**
  **Tokyo 103-0027 (JP)**
- **KAWAI, Shouhei**
  **Tokyo 103-0027 (JP)**
- **HIRAISHI, Katsufumi**
  **Tokyo 103-0027 (JP)**

(74) Representative: **Becker, Eberhard**
**Becker Kurig & Partner**
**Patentanwälte mbB**
**Bavariastraße 7**
**80336 München (DE)**

(56) References cited:
**JP-A- 2011 097 007** **JP-A- 2011 097 007**
**JP-A- 2017 064 709** **JP-A- 2017 073 348**
**JP-A- 2018 170 417**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(52) Cooperative Patent Classification (CPC): (Cont.)
B32B 2255/26; B32B 2255/28; B32B 2307/206; B32B 2307/30; B32B 2307/308; B32B 2307/538; B32B 2307/54; B32B 2307/584; B32B 2307/7246; B32B 2307/732; B32B 2307/734; B32B 2457/00; B32B 2457/206; B32B 2571/00; H05K 2201/0154

## Description

[Technical Field]

The present invention relates to a metal-clad laminate for flexible electronic devices useful as a material for various flexible electronic devices such as an organic EL display and organic EL lighting, and a flexible electronic device using the same.

[Background Art]

Display devices such as organic electroluminescence (organic EL) and liquid crystal displays and touch panels are used as components of various displays including large displays such as televisions, and medium-sized and small displays such as mobile phones, personal computers, smartphones, and in-vehicle displays. For example, an organic EL device is generally produced by forming a thin film transistor (TFT) on a glass substrate which is a support substrate, additionally sequentially forming an electrode, an organic EL layer and an electrode thereon, and hermetically sealing these with a glass substrate, a multilayer thin film or the like.

In recent years, in order to impart flexibility to an organic EL device, a flexible substrate made of a material having flexibility such as stainless steel or a resin film has been used in place of a glass substrate. A flexible substrate used in an organic EL device is required to have a gas barrier property, smoothness and an insulating property as important properties.

The gas barrier property is a property required to prevent gas components such as water vapor from permeating therethrough when a resin is used as a flexible substrate material, and influences the durability and reliability of an organic EL device used in various environment conditions.

The smoothness is important for uniformly forming a plurality of organic EL layers, and smoothness equivalent to that of a glass substrate is required.

The insulating property is required to enable independent control of a plurality of organic EL elements formed on a flexible substrate, and if the insulating property is insufficient, short-circuiting occurs between elements, which causes a malfunction.

Although a stainless steel foil used as a flexible substrate material has an excellent flexibility and gas barrier property, since smoothness and an insulating property cannot be secured, it is necessary to laminate a thin film of an organic material or an inorganic material on the stainless steel foil. For example, as a flexible substrate for an organic EL element, a stainless steel foil with an insulation coating having a structure in which a methyl group-containing silica-based coating and a phenyl group-containing silica-based coating are laminated on a stainless steel foil by a sol-gel method has been proposed (for example, Patent Literature 1). In Patent Literature 1, according to the combination of the methyl group-containing silica-based coating and the phenyl group-containing silica-based coating formed by a sol-gel method, smoothness can be secured by reducing the influence of scratches and foreign matter on the surface of the stainless steel foil.

In addition, a laminate for an organic EL element in which a polyimide film is used in place of a stainless steel foil, and an organic group-containing silica film is laminated by a sol-gel method has been proposed (for example, Patent Literature 2). However, since the polyimide film has a poorer gas barrier property than the stainless steel foil, there is a concern in terms of securing the durability and reliability of the organic EL device used in various environments. In addition, although the coating formed by a sol-gel method has excellent smoothness, the thickness needs to be reduced to about 3 μm in order not to impair the flexibility, which is insufficient in terms of securing an insulating property.

[Citation List]

[Patent Literature]

[Patent Literature 1] Japanese Patent Laid-Open No. 2013-87310
[Patent Literature 2] Japanese Patent Laid-Open No. 2017-73345

[Summary of Invention]

[Technical Problem]

As described above, a flexible substrate used for flexible electronic device applications needs to simultaneously

satisfy having three required properties, that is, a gas barrier property, smoothness and an insulating property. Therefore, as a combination of the related art, it is conceivable to improve all of the gas barrier property, the insulating property, and the smoothness by laminating a stainless steel foil, a polyimide insulation layer, and a sol-gel film. However, this has a disadvantage that the production process becomes complicated, and a disadvantage that it is difficult to control the coefficient of thermal expansion of each layer and warpage tends to occur can also be expected.

That is, when different materials having different physical properties such as metals, resins, and inorganic materials are laminated in multiple layers and composited, the occurrence of warpage tends to be a problem. In addition, since a polyimide containing many polar groups in the molecule has high hydroscopicity, there is a concern that the polyimide insulation layer may expand and contract due to seasonal fluctuations in the environment humidity, which causes unexpected warpage. In addition, it is necessary to overcome a new problem that has not been verified in Patent Literature 1 and 2 that adhesiveness between the stainless steel foil and the polyimide insulation layer needs to be secured.

Therefore, an objective of the present invention is to provide a metal-clad laminate for flexible electronic devices in which three required properties, that is, a gas barrier property, smoothness and an insulating property can be secured simultaneously, the amount of warpage is reduced, and the adhesiveness between a metal layer and a polyimide insulation layer is also excellent.

[Solution to Problem]

As a result of extensive studies performed in order to address the above problems, it has been found that the above problems can be addressed by using a layer having a specific thickness and physical properties as the polyimide insulation layer laminated on the metal layer, and thereby the present invention was completed. That is, a metal-clad laminate for flexible electronic devices of the present invention includes a metal layer and a polyimide insulation layer including a single polyimide layer or a plurality of polyimide layers laminated on one surface of the metal layer. In the metal-clad laminate for flexible electronic devices of the present invention, the polyimide insulation layer satisfies the following conditions (a) to (f);

(a) the thickness is in a range of 3 μm or more and 25 μm or less;
(b) a thickness ratio with respect to the metal layer is in a range of 0.1 or more and 0.5 or less;
(c) the coefficient of thermal expansion is 25 ppm/K or less;
(d) the coefficient of humidity expansion is 30 ppm/% RH or less;
(e) the arithmetic mean roughness (Ra) of an exposed surface that is not in contact with the metal layer is 1.0 nm or less; and
(f) a polyimide constituting the polyimide layer having an exposed surface that is not in contact with the metal layer is non-thermoplastic.

In the metal-clad laminate for flexible electronic devices of the present invention, a ratio of a tensile elastic modulus of the polyimide insulation layer to a tensile elastic modulus of the metal layer is in a range of 1/70 or more and 1/10 or less.

In the metal-clad laminate for flexible electronic devices of the present invention, the coefficient of thermal expansion of the metal layer may be in a range of 1 ppm/K or more and 25 ppm/K or less.

In the metal-clad laminate for flexible electronic devices of the present invention, the thickness of the metal layer may be in a range of 10 μm or more and 50 μm or less.

In the metal-clad laminate for flexible electronic devices of the present invention, the polyimide insulation layer may be a single layer.

In the metal-clad laminate for flexible electronic devices of the present invention, the water vapor permeability may be $10^{-6}$ g/($m^2$·day) or less.

The metal-clad laminate for flexible electronic devices of the present invention may be left in an atmosphere at 23°C and a humidity of 50% so that a convex surface at the 50 mm square center part after humidity control for 24 hours is in contact with a flat surface, and when the maximum value of raised-up amounts of four corners is set as an amount of warpage, the amount of warpage is 10 mm or less.

A flexible electronic device of the present invention includes any of the above metal-clad laminates for flexible electronic devices and an organic EL layer laminated on an exposed surface of the polyimide insulation layer that is not in contact with the metal layer in the metal-clad laminate for flexible electronic devices.

[Advantageous Effects of Invention]

In the metal-clad laminate for flexible electronic devices of the present invention, a gas barrier property,

smoothness and an insulating property are simultaneously secured, and the amount of warpage is reduced, and as notable advantages, warpage due to fluctuations in the environment humidity is unlikely to occur, and the adhesiveness between the metal layer and the polyimide insulation layer is excellent. Therefore, the metal-clad laminate for flexible electronic devices of the present invention is highly beneficial as a substrate for flexible electronic devices, and excellent durability and reliability can be imparted to the flexible electronic devices to which the metal-clad laminate is applied.

[Brief Description of Drawings]

Fig. 1 is a cross-sectional view showing a schematic configuration of a metal-clad laminate for flexible electronic devices in a thickness direction according to one embodiment of the present invention.
Fig. 2 is a cross-sectional view showing a schematic configuration of a metal-clad laminate for flexible electronic devices in a thickness direction according to another embodiment of the present invention.

[Description of Embodiments]

Hereinafter, embodiments of the present invention will be described appropriately with reference to the drawings. Fig. 1 is a cross-sectional view showing a schematic configuration of a metal-clad laminate for flexible electronic devices 30 in a thickness direction according to one embodiment of the present invention. In addition, Fig. 2 is a cross-sectional view showing a schematic configuration of a metal-clad laminate for flexible electronic devices 30 in a thickness direction according to another embodiment of the present invention.

The metal-clad laminate for flexible electronic devices 30 includes a metal layer 10 and a polyimide insulation layer 20 laminated on one surface of the metal layer 10. As shown in Fig. 1, the polyimide insulation layer 20 may be single polyimide layer, and as shown in Fig. 2, may be composed of a plurality of polyimide layers. The metal-clad laminate for flexible electronic devices 30 shown in Fig. 2 has a 2-layer structure in which the polyimide insulation layer 20 is composed of a thermoplastic polyimide layer 21 in contact with the metal layer 10 and a non-thermoplastic polyimide layer 23 laminated on the thermoplastic polyimide layer 21. Here, the polyimide insulation layer 20 may be composed of three or more layers. In addition, although not shown, the polyimide insulation layer 20 may be composed of two or more non-thermoplastic polyimide layers.

<Metal layer>

Regarding the metal layer 10, a metal foil is preferably used. The material of the metal foil is not particularly limited, and preferable examples thereof include stainless steel, titanium, Invar, and common steel. Preferable examples of stainless steel foils include austenitic SUS304 and SUS316, and ferritic SUS430 and SUS444, and commercial products can be used.

In order to reduce warpage, the coefficient of thermal expansion of the metal layer 10 is preferably in a range of 1 ppm/K or more and 25 ppm/K or less and more preferably in a range of 5 ppm/K or more and 20 ppm/K or less. If the coefficient of thermal expansion of the metal layer 10 is less than 1 ppm/K or exceeds 25 ppm/K, the difference in the coefficient of thermal expansion between it and the polyimide insulation layer 20 increases, warpage tends to occur, and the amount of warpage tends to increase.

In order to achieve balance the strength and flexibility required for a supporting base material, the thickness of the metal layer 10 is preferably in a range of 10 μm or more and 100 μm or less, more preferably in a range of 10 μm or more and 50 μm or less, and still more preferably in a range of 25 μm or more and 50 μm or less. If the thickness of the metal layer 10 is less than 10 μm, the mechanical strength becomes insufficient, and if the thickness exceeds 100 μm, the flexibility tends to decrease.

In order to achieve balance the strength and flexibility required for a supporting base material, the tensile elastic modulus of the metal layer 10 is preferably in a range of 100 GPa or more and 300 GPa or less and more preferably in a range of 200 GPa or more and 250 GPa or less. If the tensile elastic modulus of the metal layer 10 is less than 100 GPa, the mechanical strength becomes insufficient. On the other hand, if the tensile elastic modulus of the metal layer 10 exceeds 300 GPa, the flexibility tends to decrease.

<Polyimide insulation layer>

The polyimide insulation layer 20 satisfies the following conditions (a) to (f).

Condition (a):

The thickness is in a range of 3 μm or more and 25 μm or less.
If the thickness of the polyimide insulation layer 20 is less than 3 μm, it is difficult to secure an insulating property. The thickness of the polyimide insulation layer 20 is preferably 5 μm or more. On the other hand, if the thickness of the polyimide insulation layer 20 exceeds 25 μm, warpage tends to occur and the flexibility tends to decrease. The thickness of the polyimide insulation layer 20 is preferably 15 μm or less, more preferably 12 μm or less, and still more preferably 10 μm or less.
Here, even if the polyimide insulation layer 20 is composed of a plurality of layers, the thickness of the entire polyimide insulation layer 20 is within the above range.
In addition, as shown in Fig. 2, if the polyimide insulation layer 20 has a structure in which the thermoplastic polyimide layer 21 and the non-thermoplastic polyimide layer 23 are laminated, the thickness T1 of the thermoplastic polyimide layer 21 is, for example, in a range of 3 μm or less, and the thickness T2 of the non-thermoplastic polyimide layer 23 is preferably, for example, in a range of 2 μm or more and 25 μm or less. In this case, in order to control the coefficient of thermal expansion of the entire polyimide insulation layer 20 and reduce warpage, a ratio (T2/T3) of the thickness T2 of the non-thermoplastic polyimide layer 23 to the total thickness T3 of the polyimide insulation layer 20 is, for example, preferably 50% or more, and more preferably 80% or more.
Condition (b): The thickness ratio with respect to the metal layer 10 is in a range of 0.1 or more and 0.5 or less.
If the thickness ratio with respect to the metal layer 10 (the thickness of the polyimide insulation layer 20/the thickness of the metal layer 10) is less than 0.1, the surface roughness of an exposed surface of the polyimide insulation layer 20 that is not in contact with the metal layer 10 increases, and the mechanical strength decreases. On the other hand, if the thickness ratio with respect to the metal layer 10 exceeds 0.5, warpage tends to occur, the flexibility of the device substrate decreases, and the productivity tends to deteriorate.

Condition (c):

The coefficient of thermal expansion is 25 ppm/K or less.
If the coefficient of thermal expansion exceeds 25 ppm/K, warpage tends to occur in the metal-clad laminate for flexible electronic devices 30. Here, even if the polyimide insulation layer 20 is composed of a plurality of layers, the coefficient of thermal expansion of the entire polyimide insulation layer 20 may be within the above range.
In addition, the polyimide layer having an exposed surface that is not in contact with the metal layer 10 (hereinafter may be referred to as "the outmost polyimide layer") is preferably a low expansion polyimide layer having a coefficient of thermal expansion of 25 ppm/K or less. When the outmost polyimide layer is set as a low expansion polyimide layer, it is possible to effectively reduce warpage of the metal-clad laminate for flexible electronic devices 30. The low expandable polyimide layer constitutes a non-thermoplastic polyimide layer, and the high expansion polyimide layer constitutes a thermoplastic polyimide layer. Here, the low expansion polyimide layer is a polyimide layer having a coefficient of thermal expansion that is 25 ppm/K or less, preferably 20 ppm/K or less, more preferably 15 ppm/K or less, and still more preferably 12 ppm/K or less. In addition, the high-thermal-expansion polyimide layer is a polyimide layer having a coefficient of thermal expansion that is preferably 35 ppm/K or more, and more preferably in a range of 35 ppm/K or more and 80 ppm/K or less. Here, in Fig. 1, the polyimide insulation layer 20 is the outmost polyimide layer, and in Fig. 2, the non-thermoplastic polyimide layer 23 is the outmost polyimide layer. Regarding the coefficient of thermal expansion of the outmost polyimide layer, the material thereof is composed of a non-thermoplastic polyimide, a casting method in which a polyimide precursor solution is applied to the metal layer 10 is used as a forming method, and the coefficient can be controlled by controlling coating, drying, and imidization conditions.
Here, the reason why the coefficient of thermal expansion of the outmost polyimide layer is important is that, for example, as shown in Fig. 2, even if the thermoplastic polyimide layer 21 is interposed between the metal layer 10 and the outmost polyimide layer (the non-thermoplastic polyimide layer 23), the influence of the coefficient of thermal expansion of the thermoplastic polyimide layer 21 on warpage is small. That is, the relationship between the coefficients of thermal expansion of the metal layer 10 and the outmost polyimide layer is a dominant factor in occurrence and reduction of warpage. In this regard, it is preferable for the coefficient of thermal expansion $CTE_M$ of the metal layer 10 and the coefficient of thermal expansion $CTE_P$ of the outmost polyimide layer to satisfy the following relationship.

$$|CTE_P - CTE_M| \leq \pm 10 \text{ ppm/K} \quad \cdots (1)$$

Condition (d):

The coefficient of humidity expansion is 30 ppm/% RH or less.

Generally, a polyimide contains many polar groups in the molecule, and has high hydroscopicity. Therefore, the polyimide insulation layer 20 expands and contracts due to fluctuations in the environment humidity, which causes warpage. Therefore, in the present embodiment, a polyimide having a coefficient of humidity expansion that is 30 ppm/% RH or less, and preferably 15 ppm/% RH or less is used. If the polyimide insulation layer 20 is composed of a plurality of layers, the coefficient of humidity expansion of the entire polyimide insulation layer 20 may be 30 ppm/% RH or less. A specific configuration of the polyimide for reducing the coefficient of humidity expansion of the polyimide insulation layer 20 to 30 ppm/% RH or less will be described below. Here, the coefficient of humidity expansion can be measured by the method and conditions shown in examples to be described below.

Condition (e):

The arithmetic mean roughness (Ra) of the exposed surface that is not in contact with the metal layer 10 is 1.0 nm or less.

In the polyimide insulation layer 20, since the exposed surface that is not in contact with the metal layer 10 is a surface that forms a device (a device forming surface S) such as an organic EL element, the same smoothness as that of a glass substrate is required. Therefore, the arithmetic mean roughness (Ra) of the exposed surface that is not in contact with the metal layer 10 needs to be 1.0 nm or less, and is preferably 0.6 nm or less, and more preferably 0.4 nm or less. Here, in Fig. 1, the surface of the polyimide insulation layer 20 is the device forming surface S, and in Fig. 2, the surface of the non-thermoplastic polyimide layer 23 is the device forming surface S.

Regarding the arithmetic mean roughness (Ra) of the device forming surface S, the polyimide layer (the outmost polyimide layer) having an exposed surface that is not in contact with the metal layer 10 is composed of a non-thermoplastic polyimide, a casting method in which a polyimide precursor solution is applied to the metal layer 10 is used as a forming method thereof, and the roughness can be controlled by controlling coating, drying, and imidization conditions.

Condition (f):

The polyimide constituting the polyimide layer having an exposed surface that is not in contact with the metal layer 10 is non-thermoplastic.

Since the polyimide layer (the outmost polyimide layer) having an exposed surface that is not in contact with the metal layer 10 is composed of a non-thermoplastic polyimide, the coefficient of thermal expansion is easily controlled and warpage is reduced. In addition, when the outmost polyimide layer is formed of a non-thermoplastic polyimide, it is possible to reduce the arithmetic mean roughness (Ra) of the device forming surface S which is an exposed surface that is not in contact with the metal layer 10, and the smoothness is secured. A specific configuration of the non-thermoplastic polyimide used for the outmost polyimide layer will be described below.

In order to achieve balance the strength and flexibility required for an insulation resin layer, the tensile elastic modulus of the polyimide insulation layer 20 is preferably in a range of 3 GPa or more and 15 GPa or less and more preferably in a range of 5 GPa or more and 12 GPa or less. If the tensile elastic modulus of the polyimide insulation layer 20 is less than 3 GPa, the mechanical strength becomes insufficient. On the other hand, if the tensile elastic modulus of the polyimide insulation layer 20 exceeds 15 GPa, the insulation resin layer becomes brittles and the flexibility tends to decrease.

A ratio of the tensile elastic modulus of the polyimide insulation layer 20 to the tensile elastic modulus of the metal layer 10 (the tensile elastic modulus of the polyimide insulation layer 20/the tensile elastic modulus of the metal layer 10) is preferably in a range of 1/70 or more and 1/10 or less. Within such a range, warpage can be reduced and the flexibility can be secured, which is suitable for an electronic device substrate.

Next, a non-thermoplastic polyimide and a thermoplastic polyimide for forming the polyimide insulation layer 20 will be described. Here, the "non-thermoplastic polyimide" is generally a polyimide that does not soften nor exhibit adhesiveness even when heated, but in the present invention, it is a polyimide having a storage modulus at 30°C of $1.0\times10^9$ Pa or more and a storage modulus at 350°C of $1.0\times10^8$ Pa or more measured using a dynamic viscoelasticity measurement device (DMA). In addition, the "thermoplastic polyimide" is a polyimide in which the generally glass transition temperature (Tg) can be clearly confirmed, but in the present invention, it is a polyimide having a storage modulus at 30°C of $1.0\times10^9$ Pa or more and a storage modulus at 350°C of less than $1.0\times10^8$ Pa measured using the DMA.

Non-thermoplastic polyimide:

The non-thermoplastic polyimide constituting the non-thermoplastic polyimide layer 23 contains a tetracarboxylic acid residue and a diamine residue. Here, in the present invention, the tetracarboxylic acid residue indicates a

tetravalent group derived from tetracarboxylic dianhydride, and the diamine residue indicates a divalent group derived from a diamine compound. The non-thermoplastic polyimide preferably contains an aromatic tetracarboxylic acid residue derived from an aromatic tetracarboxylic dianhydride and an aromatic diamine residue derived from an aromatic diamine.

(Tetracarboxylic acid residue)

The non-thermoplastic polyimide preferably contains, as tetracarboxylic acid residues, a tetracarboxylic acid residue derived from at least one of 3,3',4,4'-biphenyltetracarboxylic dianhydride (BPDA) and 1,4-phenylenebis(trimellitic acid monoester)dianhydride (TAHQ), and a tetracarboxylic acid residue derived from at least one of pyromellitic acid dianhydride (PMDA) and 2,3,6,7-naphthalenetetracarboxylic dianhydride (NTCDA).

The tetracarboxylic acid residue derived from BPDA (hereinafter referred to as "BPDA residue") and the tetracarboxylic acid residue derived from TAHQ (hereinafter referred to as "TAHQ residue") easily form an ordered structure of polymers, and can reduce the hydroscopicity by restricting movement of molecules. The BPDA residue can impart self-supporting properties of a gel film as a polyamic acid of a polyimide precursor, but on the other hand, it increases the CTE after imidization, lowers the glass transition temperature, and tends to lower the heat resistance.

In addition, since the tetracarboxylic acid residue derived from pyromellitic acid dianhydride (hereinafter referred to as "PMDA residue") and the tetracarboxylic acid residue derived from 2,3,6,7-naphthalenetetracarboxylic dianhydride (hereinafter referred to as "NTCDA residue") have rigidity, they are residues having functions of improving the in-plane orientation, reducing the CTE to a low level, and controlling the glass transition temperature. On the other hand, since the PMDA residue has a small molecular weight, if the amount thereof is too large, the imide group concentration of the polymer increases, the number of polar groups increases, and the hydroscopicity increases. In addition, the NTCDA residue tends to make the film brittle due to a naphthalene framework having high rigidity, and tends to increase the elastic modulus.

In view of the above points, in the non-thermoplastic polyimide constituting the non-thermoplastic polyimide layer 23, a total amount of at least one of the BPDA residue and the TAHQ residue and at least one of the PMDA residue and the NTCDA residue is 80 parts by mole or more and preferably 90 parts by mole or more with respect to 100 parts by mole of the entire tetracarboxylic acid residues.

Since the PMDA and NTCDA have a rigid framework, it is possible to control the in-plane orientation of molecules in the polyimide, compared to other general acid anhydride components, they have an effect of reducing the coefficient of thermal expansion (CTE) and improving the glass transition temperature (Tg). In addition, since the BPDA and the TAHQ have a larger molecular weight than the PMDA, the imide group concentration decreases as the preparation ratio increases, which is effective in reducing the hygroscopicity. On the other hand, when the preparation ratio of the BPDA and the TAHQ increases, the in-plane orientation of molecules in the polyimide deteriorates, which leads to an increase in the CTE. In this regard, a total amount of the PMDA and the NTCDA prepared is preferably 40 parts by mole or more with respect to 100 parts by mole of the entire acid anhydride components of the raw material. If a total amount of the PMDA and the NTCDA prepared is less than 40 parts by mole with respect to 100 parts by mole of the entire acid anhydride components of the raw material, the in-plane orientation of molecules decreases, it is difficult to reduce the CTE, and the heat resistance and dimensional stability of the film during heating decrease due to a decrease in the Tg.

In addition, the BPDA and the TAHQ are effective in restricting movement of molecules and in reducing hygroscopicity due to a decrease in the imide group concentration, but increase the CTE for a polyimide film after imidization. In this regard, a total amount of the BPDA and the TAHQ prepared is preferably not more than 60 parts by mole and more preferably in a range of 20 to 50 parts by mole with respect to 100 parts by mole of the entire acid anhydride components of the raw material.

Examples of tetracarboxylic acid residues other than the BPDA residue, the TAHQ residue, the PMDA residue, and the NTCDA residue, which are contained in the non-thermoplastic polyimide constituting the non-thermoplastic polyimide layer 23, include tetracarboxylic acid residues derived from aromatic tetracarboxylic dianhydrides such as 3,3',4,4'-diphenyl sulfone tetracarboxylic dianhydride, 4,4'-oxydiphthalic acid anhydride, 2,3',3,4'-biphenyltetracarboxylic dianhydride, 2,2',3,3'-, 2,3,3',4'- or 3,3',4,4'-benzophenone tetracarboxylic dianhydride, 2,3',3,4'-diphenyl ether tetracarboxylic dianhydride, bis(2,3-dicarboxyphenyl)ether dianhydride, 3,3",4,4"-, 2,3,3",4"- or 2,2'',3,3''-p-terphenyltetracarboxylic dianhydride, 2,2-bis(2,3- or 3,4-dicarboxyphenyl)-propane dianhydride, bis(2,3- or 3.4-dicarboxyphenyl) methane dianhydride, bis(2,3- or 3,4-dicarboxyphenyl)sulfone dianhydride, 1,1-bis(2,3- or 3,4-dicarboxyphenyl)ethane dianhydride, 1,2,7,8-, 1,2,6,7- or 1,2,9,10-phenanthrene-tetracarboxylic dianhydride, 2,3,6,7-anthracenetetracarboxylic dianhydride, 2,2-bis(3,4-dicarboxyphenyl)tetrafluoropropane dianhydride, 2,3,5,6-cyclohexane dianhydride, 1,2,5,6-naphthalenetetracarboxylic dianhydride, 1,4,5,8-naphthalenetetracarboxylic dianhydride, 4,8-dimethyl-1,2,3,5,6,7-hexahydronaphthalene-1,2,5,6-tetracarboxylic dianhydride, 2,6- or 2,7-dichloronaphthalene-1,4,5,8-tetracarboxylic dianhydride, 2,3,6,7-(or 1,4,5,8-)tetrachloro naphthalene-1,4,5,8-(or 2,3,6,7-)tetracarboxylic dianhydride, 2,3,8,9-3,4,9,10-, 4,5,10,11- or 5,6,11,12-perylene-tetracarboxylic dianhydride, cyclopentane-1,2,3,4-tetracarboxylic dianhydride, pyrazine-2,3,5,6-tetracarboxylic dianhydride, pyrrolidine-2,3,4,5-tetracarboxylic dianhydride, thiophene-2,3,4,5-tetracarboxylic dianhydride, 4,4'-bis(2,3-dicarboxyphenoxy)diphenylmethane dianhydride, and ethylene glycol bisanhydrotrimellitate.

(Diamine residue)

As the diamine residue contained in the non-thermoplastic polyimide constituting the non-thermoplastic polyimide layer 23, a diamine residue derived from the diamine compound represented by General Formula (1) is present

[Chem. 1]

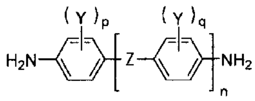

... (1)

In Formula (1), the linking group Z indicates a single bond, -COO-, or -NHCO-, Y independently indicates a halogen atom, a monovalent hydrocarbon having 1 to 3 carbon atoms or an alkoxy group or alkenyl group having 1 to 3 carbon atoms, which may be substituted with a phenyl group, n indicates an integer of 0 to 2, and p and q independently indicate an integer of 0 to 4. Here, "independently" means that, in Formula (1), the plurality of substituents Y, and the integers p and q may be the same as or different from each other. Here, in Formula (1), hydrogen atoms in terminal two amino groups may be substituted, and may be, for example, $-NR_2R_3$ (where, $R_2$ and $R_3$ independently indicate arbitrary substituents such as an alkyl group).

The diamine compound represented by General Formula (1) (hereinafter may be referred to as a "diamine (1)") is an aromatic diamine having one to three benzene rings. Since the diamine (1) has rigid structure, it has a function of imparting the ordered structure to the entire polymers. Therefore, a polyimide having low gas permeability and low hydroscopicity is obtained, and water in the molecular chain can be reduced. Here, the linking group Z is preferably a single bond.

Examples of diamines (1) include 1,4-diaminobenzene (p-PDA; paraphenylene diamine), 2,2'-dimethyl-4,4'-diaminobiphenyl (m-TB), 2,2'-diethyl-4,4'-diaminobiphenyl (m-EB), 2,2'-diethoxy-4,4'-diaminobiphenyl (m-EOB), 2,2'-dipropoxy-4,4'-diaminobiphenyl (m-POB), 2,2'-n-propyl-4,4'-diaminobiphenyl (m-NPB), 2,2'-divinyl-4,4'-diaminobiphenyl (VAB), 4,4'-diaminobiphenyl, 4,4'-diamino-2,2'-bis (trifluoromethyl)biphenyl (TFMB), 4-aminophenyl-4'-aminobenzoate (APAB), and 4,4'-diamino-2'-methoxybenzanilide (MABA).

The non-thermoplastic polyimide constituting the non-thermoplastic polyimide layer 23 may contain preferably 20 parts by mole or more, and more preferably 50 parts by mole or more of the diamine residue derived from the diamine (1) with respect to 100 parts by mole of the entire diamine residues. When the amount of the diamine (1) used is within the above range, the ordered structure is easily formed in the entire polymers according to the rigid structure derived from the monomers, and a non-thermoplastic polyimide having low gas permeability and low hydroscopicity is easily obtained.

Examples of other diamine residues contained in the non-thermoplastic polyimide constituting the non-thermoplastic polyimide layer 23 include diamine residues derived from aromatic diamine compounds such as 2,2-bis-[4-(3-aminophenoxy)phenyl]propane, bis[4-(3-aminophenoxy)phenyl]sulfone, bis[4-(3-aminophenoxy)biphenyl, bis[1-(3-aminophenoxy)]biphenyl, bis[4-(3-aminophenoxy)phenyl]methane, bis[4-(3-aminophenoxy)phenyl]ether, bis[4-(3-aminophenoxy)]benzophenone, 9,9-bis[4-(3-aminophenoxy)phenyl]fluorene, 2,2-bis-[4-(4-aminophenoxy)phenyl]hexafluoropropane, 2,2-bis-[4-(3-aminophenoxy)phenyl]hexafluoropropane, 3,3'-dimethyl-4,4'-diaminobiphenyl, 4,4'-methylenedi-o-toluidine, 4,4'-methylenedi-2,6-xylidine, 4,4'-methylene-2,6-diethylaniline, 3,3'-diaminodiphenylethane, 3,3'-diaminobiphenyl, 3,3'-dimethoxybenzidine, 3,3''-diamino-p-terphenyl, 4,4'-[1,4-phenylenebis(1-methylethylidene)]bisaniline, 4,4'-[1,3-phenylenebis(1-methylethylidene)]bisaniline, bis(p-aminocyclohexyl)methane, bis(p-β-amino-t-butylphenyl) ether, bis(p-β-methyl-δ-aminopentyl)benzene, p-bis(2-methyl-4-aminopentyl)benzene, p-bis(1,1-dimethyl-5-aminopentyl)benzene, 1,5-diaminonaphthalene, 2,6-diaminonaphthalene, 2,4-bis(β-amino-t-butyl)toluene, 2,4-diaminotoluene, m-xylene-2,5-diamine, p-xylene-2,5-diamine, m-xylenediamine, p-xylylene diamine, 2,6-diaminopyridine, 2,5-diaminopyridine, 2,5-diamino-1,3,4-oxadiazole, piperazine, 2'-methoxy-4,4'-diaminobenzanilide, 4,4'-diaminobenzanilide, 1,3-bis[2-(4-aminophenyl)-2-propyl]benzene, 6-amino-2-(4-aminophenoxy)benzoxazole, and 4,4'-diaminodiphenyl ether, and diamine residues derived from aliphatic diamine compounds such as a dimer acid type diamine in which two terminal carboxylic acid groups of a dimer acid are substituted with a primary aminomethyl group or an amino group.

In the non-thermoplastic polyimide, when the types of the tetracarboxylic acid residues and the diamine residues, and the molar ratio when two or more types of tetracarboxylic acid residues or diamine residues are applied are selected, it is possible to control the coefficient of thermal expansion, the storage modulus, the tensile elastic modulus, and the like. In addition, in the non-thermoplastic polyimide, when the polyimides have a plurality of structural units, they may be present as a block or randomly, and the polyimides are preferably present randomly.

Here, it is preferable to set both the tetracarboxylic acid residue and the diamine residue contained in the non-thermoplastic polyimide as aromatic groups because the dimensional accuracy of the polyimide film in a high temperature environment can be improved.

The non-imide group concentration of the thermoplastic polyimide is preferably 33% or less and more preferably 32% or less. Here, the "imide group concentration" is a value obtained by dividing the molecular weight of the imide group moiety ($-(CO)_2-N-$) in the polyimide by the molecular weight of the entire structure of the polyimide. If the imide group concentration exceeds 33%, the molecular weight of the resin itself decreases, and the hydroscopicity increases due to an increase in the number of polar groups. When a combination of the acid anhydride and the diamine compound is selected, the orientation of molecules in the non-thermoplastic polyimide is controlled, and thus an increase in the CTE due to a decrease in the imide group concentration is reduced, and low hydroscopicity is secured.

The weight-average-molecular weight of the non-thermoplastic polyimide is, for example, preferably in a range of 10,000 to 400,000 and more preferably in a range of 50,000 to 350,000. If the weight-average-molecular weight is less than 10,000, the strength of the film decreases and the film tends to be brittle. On the other hand, if the weight-average-molecular weight exceeds 400,000, the viscosity excessively increases, and defects such as film thickness unevenness and streaks tend to easily occur during a coating operation.

The glass transition temperature (Tg) of the non-thermoplastic polyimide layer 23 is preferably 280°C or higher in consideration of heat resistance.

In addition, as optional components, for example, a plasticizer, other curing resin components such as an epoxy resin, a curing agent, a curing accelerator, a coupling agent, a filler, a solvent, and a flame retardant can be appropriately added to the non-thermoplastic polyimide constituting the non-thermoplastic polyimide layer 23.

Thermoplastic polyimide:

Since the thermoplastic polyimide layer 21 is interposed between the metal layer 10 and the non-thermoplastic polyimide layer 23 and functions as an adhesive layer, it is preferable to have excellent adhesiveness. The thermoplastic polyimide constituting the thermoplastic polyimide layer 21 contains the tetracarboxylic acid residue and the diamine residue, and preferably contains an aromatic tetracarboxylic acid residue derived from an aromatic tetracarboxylic dianhydride and an aromatic diamine residue derived from an aromatic diamine.

(Tetracarboxylic acid residue)

Regarding the tetracarboxylic acid residue used in the thermoplastic polyimide constituting the thermoplastic polyimide layer 21, those exemplified as the tetracarboxylic acid residue in the non-thermoplastic polyimide constituting the non-thermoplastic polyimide layer 23 can be used.

(Diamine residue)

As the diamine residue contained in the thermoplastic polyimide constituting the thermoplastic polyimide layer 21, a diamine residue derived from diamine compounds represented by General Formulae (B1) to (B7) is preferable.

[Chem. 2]

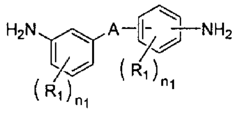

··· (B1)

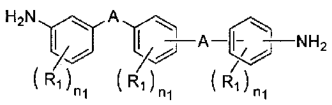

··· (B2)

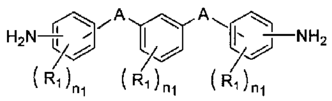

··· (B3)

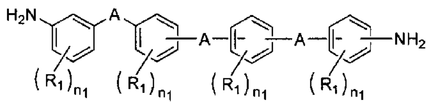

··· (B4)

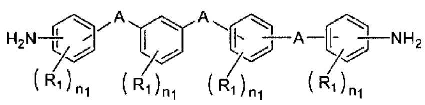

··· (B5)

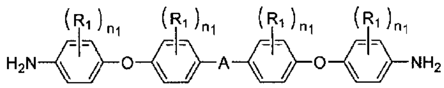

··· (B6)

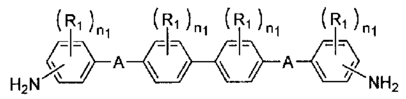

··· (B7)

In Formulae (B1) to (B7), $R_1$ independently indicates a monovalent hydrocarbon group or alkoxy group having 1 to 6 carbon atoms, the linking group A independently indicates a divalent group selected from among -O-, -S-, -CO-, -SO-, $-SO_2-$, -COO-, $-CH_2-$, $-C(CH_3)_2-$, -NH- and -CONH-, and $n_1$ independently indicates an integer of 0 to 4. However, duplicated parts of Formula (B3) to Formula (B2) are excluded, and duplicated parts of Formula (B5) to Formula (B4) are excluded. Here, "independently" means that, in one or two or more parts in one of Formulae (B1) to (B7), a plurality of linking groups A's, a plurality of $R_1$'s or a plurality of $n_1$'s may be the same as or different from each other. Here, in Formulae (B1) to (B7), hydrogen atoms in the two terminal amino groups may be substituted, and for example, $-NR_3R_4$ (where, $R_3$ and $R_4$ independently indicate an arbitrary substituent such as an alkyl group) may be used.

The diamine represented by Formula (B1) (hereinafter may be referred to as a "diamine (B1)") is an aromatic diamine having two benzene rings. It is conceivable that the diamine (B 1) has an amino group directly linked to at least one benzene ring and a divalent linking group A at the meta positions and thus has a high degree of freedom of the polyimide molecular chain and high bendability, and contributes to improvement of the flexibility of the polyimide molecular chain. Therefore, when the diamine (B1) is used, the thermoplasticity of the polyimide is improved. Here, the linking group A is preferably -O-, $-CH_2-$, $-C(CH_3)_2-$, -CO-, $-SO_2-$, or -S-.

Examples of diamines (B 1) include 3,3'-diaminodiphenylmethane, 3,3'-diaminodiphenylpropane, 3,3'-diaminodiphenyl sulfide, 3,3'-diaminodiphenyl sulfone, 3,3'-diaminodiphenyl ether, 3,4'-diaminodiphenyl ether, 3,4'-diaminodiphenylmethane, 3,4'-diaminodiphenylpropane, 3,4'-diaminodiphenylsulfide, 3,3'-diaminobenzophenone, and (3,3'-bisamino)diphenylamine.

The diamine represented by Formula (B2) (hereinafter may be referred to as a "diamine (B2)") is an aromatic diamine having three benzene rings. It is conceivable that the diamine (B2) has an amino group directly linked to at least one benzene ring and a divalent linking group A at the meta positions and thus has a high degree of freedom of the polyimide molecular chain and high bendability, and contributes to improvement of the flexibility of the polyimide molecular chain. Therefore, when the diamine (B2) is used, the thermoplasticity of the polyimide is improved. Here, the linking group A is preferably -O-.

Examples of diamines (B2) include 1,4-bis(3-aminophenoxy)benzene, 3-[4-(4-aminophenoxy)phenoxy]benzenamine, and 3-[3-(4-aminophenoxy)phenoxy]benzenamine.

The diamine represented by Formula (B3) (hereinafter may be referred to as a "diamine (B3)") is an aromatic diamine having three benzene rings. It is conceivable that the diamine (B3) has two divalent linking groups A directly linked to one benzene ring at the meta positions and thus has a high degree of freedom of the polyimide molecular chain and high bendability, and contributes to improvement of the flexibility of the polyimide molecular chain. Therefore, when the diamine

(B3) is used, the thermoplasticity of the polyimide is improved. Here, the linking group A is preferably -O-.

Examples of diamines (B3) include 1,3-bis(4-aminophenoxy)benzene (TPE-R), 1,3-bis(3-aminophenoxy)benzene (APB), 4,4'-[2-methyl-(1,3-phenylene)bisoxy]bisaniline, 4,4'-[4-methyl-(1,3-phenylene)bisoxy]bisaniline, and 4,4'-[5-methyl-(1,3-phenylene)bisoxy]bisaniline.

The diamine represented by Formula (B4) (hereinafter may be referred to as a "diamine (B4)") is an aromatic diamine having four benzene rings. It is conceivable that the diamine (B4) has an amino group directly linked to at least one benzene ring and a divalent linking group A at the meta positions and thus has high bendability, and contributes to improvement of the flexibility of the polyimide molecular chain. Therefore, when the diamine (B4) is used, the thermoplasticity of the polyimide is improved. Here, the linking group A is preferably -O-, $-CH_2-$, $-C(CH_3)_2-$, $-SO_2-$, -CO-, or -CONH-.

Examples of diamines (B4) include bis[4-(3-aminophenoxy)phenyl]methane, bis[4-(3-aminophenoxy)phenyl]propane, bis[4-(3-aminophenoxy)phenyl]ether, bis[4-(3-aminophenoxy)phenyl]sulfone, bis[4-(3-aminophenoxy)]benzophenone, and bis[4,4'-(3-aminophenoxy)]benzanilide.

The diamine represented by Formula (B5) (hereinafter may be referred to as a "diamine (B5)") is an aromatic diamine having four benzene rings. It is conceivable that the diamine (B5) has two divalent linking groups A directly linked to at least one benzene ring at the meta positions, and thus has a high degree of freedom of the polyimide molecular chain and high bendability, and contributes to improvement of the flexibility of the polyimide molecular chain. Therefore, when the diamine (B5) is used, the thermoplasticity of the polyimide is improved. Here, the linking group A is preferably -O-.

Examples of diamines (B5) include 4-[3-[4-(4-aminophenoxy)phenoxy]phenoxy]aniline, and 4,4'-[oxybis(3,1-phenyleneoxy)]bisaniline.

The diamine represented by Formula (B6) (hereinafter may be referred to as a "diamine (B6)") is an aromatic diamine having four benzene rings. It is conceivable that the diamine (B6) has at least two ether bonds and thus has high bendability, and contributes to improvement of the flexibility of the polyimide molecular chain. Therefore, when the diamine (B6) is used, the thermoplasticity of the polyimide is improved. Here, the linking group A is preferably $-C(CH_3)_2-$, -O-, $-SO_2-$, or -CO-.

Examples of diamines (B6) include 2,2-bis[4-(4-aminophenoxy)phenyl]propane (BAPP), bis[4-(4-aminophenoxy)phenyl]ether (BAPE), bis[4-(4-aminophenoxy)phenyl]sulfone (BAPS), and bis[4-(4-aminophenoxy)phenyl]ketone (BAPK).

The diamine represented by Formula (B7) (hereinafter may be referred to as a "diamine (B7)") is an aromatic diamine having four benzene rings. It is conceivable that, since the diamine (B7) has a divalent linking group A having high bendability on both sides of a diphenyl framework, it contributes to improving the flexibility of the polyimide molecular chain. Therefore, when the diamine (B7) is used, the thermoplasticity of the polyimide is improved. Here, the linking group A is preferably -O-.

Examples of diamines (B7) include bis[4-(3-aminophenoxy)]biphenyl and bis[4-(4-aminophenoxy)]biphenyl.

The thermoplastic polyimide constituting the thermoplastic polyimide layer 21 may contain 60 parts by mole or more, preferably a range of 60 parts by mole or more and 100 parts by mole or less, and more preferably a range of 70 parts by mole or more and 100 parts by mole or less of the diamine residue derived from at least one diamine compound selected from among the diamine (B1) to the diamine (B7) with respect to 100 parts by mole of the entire diamine residues. Since the diamine (B1) to the diamine (B7) have a molecular structure having bendability, if at least one diamine compound selected from these is used in an amount within the above range, the flexibility of the polyimide molecular chain is improved, and thermoplasticity can be imparted. If a total amount of the diamine (B 1) to the diamine (B7) in the raw material is less than 60 parts by mole with respect to 100 parts by mole of the entire diamine components, the flexibility of the polyimide resin is insufficient and sufficient thermoplasticity cannot be obtained.

In addition, as the diamine residue contained in the thermoplastic polyimide constituting the thermoplastic polyimide layer 21, a diamine residue derived from the diamine compound represented by General Formula (1) is also preferable. The diamine compound represented by Formula (1) [diamine (1)] is the same as those described in the non-thermoplastic polyimide. Since the diamine (1) has a rigid structure and a function of imparting the ordered structure to the entire polymers, it can reduce the hydroscopicity by restricting movement of molecules. In addition, when a thermoplastic polyimide raw material is used, a polyimide having low gas permeability and excellent long-term heat resistant adhesiveness is obtained.

The thermoplastic polyimide constituting the thermoplastic polyimide layer 21 may contain preferably a range of 1 part by mole or more and 40 parts by mole or less, and more preferably a range of 5 parts by mole or more and 30 parts by mole or less of the diamine residue derived from the diamine (1). When the amount of the diamine (1) used is within the above range, since the ordered structure is formed in the entire polymers due to a rigid structure derived from monomers, a polyimide which is thermoplastic and has low gas permeability and hydroscopicity, and excellent long-term heat resistant adhesiveness is obtained.

The thermoplastic polyimide constituting the thermoplastic polyimide layer 21 may contain a diamine residue derived from a diamine compound other than the diamines (1), and (B1) to (B7) as long as the effects of the invention are

not impaired.

In the thermoplastic polyimide, when the types of the tetracarboxylic acid residues and the diamine residues, and the molar ratio when two or more types of tetracarboxylic acid residues or diamine residues are applied are selected, it is possible to control the coefficient of thermal expansion, the tensile elastic modulus, the glass transition temperature, and the like. In addition, in the thermoplastic polyimide, when the polyimides have a plurality of structural units, they may be present as a block or randomly, and the polyimides are preferably present randomly.

Here, when both the tetracarboxylic acid residue and the diamine residue contained in the thermoplastic polyimide are set as aromatic groups, it is possible to improve the dimensional accuracy of the polyimide film in a high temperature environment.

The imide group concentration of the thermoplastic polyimide is preferably 33% or less and more preferably 32% or less. Here, the "imide group concentration" is a value obtained by dividing the molecular weight of the imide group moiety ($-(CO)_2-N-$) in the polyimide by the molecular weight of the entire structure of the polyimide. If the imide group concentration exceeds 33%, the molecular weight of the resin itself decreases, and the hydroscopicity increases due to an increase in the number of polar groups. When a combination of the diamine compounds is selected, the orientation of molecules in the non-thermoplastic polyimide is controlled, and thus an increase in the CTE due to a decrease in the imide group concentration is reduced, and low hydroscopicity is secured.

The weight-average-molecular weight of the thermoplastic polyimide is, for example, preferably in a range of 10,000 to 400,000 and more preferably in a range of 50,000 to 350,000. If the weight-average-molecular weight is less than 10,000, the strength of the film decreases and the film tends to be brittle. On the other hand, if the weight-average-molecular weight exceeds 400,000, the viscosity excessively increases, and defects such as film thickness unevenness and streaks tend to easily occur during a coating operation.

Since the thermoplastic polyimide constituting the thermoplastic polyimide layer 21 is interposed between the metal layer 10 and the non-thermoplastic polyimide layer 23 and functions as an adhesive layer, a completely imidized structure is most preferable in order to prevent diffusion of metal elements into the polyimide insulation layer 20. However, a part of the polyimide may be an amic acid. An infrared absorption spectrum of a polyimide thin film is measured using a Fourier transform infrared spectrophotometer (FT/IR620 commercial product: commercially available from JASCO Corporation) according to a single reflection ATR method, and the imidization rate is calculated from the absorbance of C=O expansion and contraction derived from the imide group at 1,780 $cm^{-1}$ based on a benzene ring absorber near 1,015 $cm^{-1}$.

In addition, in addition to the polyimide, as optional components, for example, a plasticizer, other curing resin components such as an epoxy resin, a curing agent, a curing accelerator, an inorganic filler, a coupling agent, a filler, a solvent, and a flame retardant can be appropriately added to the resin used for the thermoplastic polyimide layer 21.

(Synthesis of polyimide)

The polyimide constituting the polyimide insulation layer 20 can be produced by reacting the acid anhydride and the diamine in a solvent to produce a precursor resin and then heating and closing the ring. For example, approximately equal molar amounts of the acid anhydride component and the diamine component are dissolved in an organic solvent, the mixture is stirred in a temperature range of 0 to 100°C for 30 minutes to 24 hours, a polymerization reaction is caused, and a polyamic acid which is a polyimide precursor is obtained. In the reaction, reaction components are dissolved in an organic solvent so that the amount of the precursor to be produced is in a range of 5 to 30 wt%, preferably a range of 10 to 20 wt%. Examples of organic solvents used in the polymerization reaction include N,N-dimethylformamide, N,N-dimethylacetamide (DMAc), N-methyl-2-pyrrolidone, 2-butanone, dimethylsulfoxide, dimethyl sulfate, cyclohexanone, dioxane, tetrahydrofuran, diglyme, and triglyme. Two or more of these solvents can be used in combination, and additionally, aromatic hydrocarbons such as xylene and toluene can be used in combination. In addition, the amount of such an organic solvent used is not particularly limited, but preferably, the amount used is adjusted so that the concentration of the polyamic acid solution (polyimide precursor solution) obtained by the polymerization reaction is about 5 to 30 wt%.

**In** the polyimide synthesis, each of the acid anhydride and the diamine may be used alone or two or more types thereof may be used in combination. When the types of the acid anhydride and the diamine, and the molar ratio when two or more types of acid anhydrides or diamines are used are selected, it is possible to control the thermal expansion, the adhesiveness, the glass transition temperature and the like.

The synthesized precursor is generally advantageous for use as a reaction solvent solution, but as necessary, it can be concentrated, diluted or replaced with another organic solvent. **In** addition, the precursor generally has excellent solvent solubility, and thus its use is favorable. The method of imidizing the precursor is not particularly limited, and for example, a heat treatment such as heating in a temperature condition range of 80 to 400°C for 1 to 24 hours in the solvent, is suitably used.

The metal-clad laminate for flexible electronic devices 30 according to the present embodiment having the above configuration is left in an atmosphere at 23°C and a humidity of 50% so that the convex surface at the 50 mm square center

part after humidity control for 24 hours is in contact with a flat surface, and when the maximum value of the raised-up amounts of four corners is set as an amount of warpage, the amount of warpage is 10 mm or less. If the amount of warpage exceeds 10 mm, handling properties deteriorate, and it is difficult to form an organic EL layer on the device forming surface S (the exposed surface that is not in contact with the metal layer 10) of the polyimide insulation layer 20.

**In** the metal-clad laminate for flexible electronic devices 30 according to the present embodiment, in order to secure a gas barrier property, the water vapor permeability is preferably $10^{-6}$ g/($m^2$·day) or less.

[Method of producing metal-clad laminate for flexible electronic devices]

**In** the metal-clad laminate for flexible electronic devices 30 according to the present embodiment, the polyimide insulation layer 20 is preferably formed by a so-called casting method. The casting method is a method in which a resin solution of a polyamic acid, which is a polyimide precursor, is applied to a metal foil, which is a raw material of the metal layer 10, and a coating film is formed, and then dried and cured by a heat treatment. **In** the casting method, it is easy to control the thickness, the coefficient of thermal expansion, and the coefficient of humidity expansion of the polyimide insulation layer 20, and the smoothness of the device forming surface S in the polyimide insulation layer 20 and adhesion to the metal layer 10.

**In** the casting method, the coating film can be formed by applying a polyamic acid resin solution to a metal foil that is the metal layer 10 and then drying. **In** this case, the film can be formed by sequentially applying other polyamic acid solutions composed of different constituent components to a polyamic acid solution, or a polyamic acid solution having the same configuration may be applied twice or more. **In** addition, multi-layered coating films may be simultaneously laminated and formed by multi-layer extrusion. **In** addition, a polyamic acid coating film is once imidized to form a single polyimide layer or a plurality of polyimide layers, and then a polyamic acid resin solution is additionally applied thereto to cause imidization, and thereby the polyimide insulation layer 20 can be formed. The coating method is not particularly limited, and for example, coating can be performed with a coater such as a comma, a die, a knife, or a lip. **In** this case, a stainless steel foil having a cut sheet shape, a roll shape, or an endless belt shape can be used. **In** order to obtain productivity, it is efficient to use a roll form or an endless belt form so that continuous production is possible.

The imidization method is not particularly limited, and for example, a heat treatment such as heating in a temperature condition range of 80 to 400°C and a time range of 1 to 60 minutes is suitably used. **In** order to minimize oxidation of the metal layer 10, a heat treatment in a low oxygen atmosphere is preferable, and specifically, is preferably performed in an inert gas atmosphere such as a nitrogen or rare gas, a reduction gas atmosphere such as hydrogen, or in a vacuum. According to the heat treatment, the polyamic acid in the coating film is imidized to form a polyimide.

Regarding the method of producing the metal-clad laminate for flexible electronic devices 30 according to the present embodiment, a case in which the metal-clad laminate for flexible electronic devices 30 in which the metal layer 10 is a stainless steel layer is produced by the casting method will be exemplified and described in more detail.

First, a stainless steel foil is prepared. Then, a polyamic acid resin solution is applied to the stainless steel foil and dried to form a first-layer coating film. The first-layer coating film is a precursor resin layer of the non-thermoplastic polyimide in the embodiment shown in Fig. 1, and a precursor resin layer of the thermoplastic polyimide in the embodiment shown in Fig. 2. In the embodiment shown in Fig. 2, a polyamic acid resin solution is additionally applied to the first-layer coating film and dried to form a second-layer coating film. In this case, the second-layer coating film is a precursor resin layer of the non-thermoplastic polyimide. As necessary, third-or subsequent layer coating films may be sequentially formed in the same manner while selecting the type of the polyamic acid.

Then, when the single precursor resin layer or the plurality of precursor resin layers are heated and polyamic acids of the precursor resin layers are imidized, the metal-clad laminate for flexible electronic devices 30 in which the single polyimide insulation layer 20 or the plurality of polyimide insulation layers 20 are laminated on the stainless steel layer as the metal layer 10 can be produced.

[Flexible electronic device]

The flexible electronic device according to one embodiment of the present invention includes the metal-clad laminate for flexible electronic devices 30. For example, when the flexible electronic device is an organic EL device, although not shown, it includes the metal-clad laminate for flexible electronic devices 30 and a layer containing an organic EL element (organic EL layer) laminated on the device forming surface S (the exposed surface that is not in contact with the metal layer 10) of the polyimide insulation layer 20 in the metal-clad laminate for flexible electronic devices 30. Here, the organic EL layer and other configurations are the same as those of a general flexible organic EL device.

Examples

Hereinafter, the contents of the present invention will be described in detail with reference to examples, but the

present invention is not limited to the scope of these examples. Here, in the following examples, unless otherwise specified, various measurements and evaluations are as follows.

[Measurement of viscosity]

The viscosity of a polyamic acid solution obtained in a synthesis example was measured at 25°C using a cone plate type viscometer with a constant temperature bath (commercially available from Tokimec Co., Ltd.).

[Measurement of coefficient of thermal expansion (CTE)]

1) CTE of polyimide film

A polyimide film having a size of 3 mm×20 mm was heated from 30°C to 250°C at a temperature rise rate of 10°C/min while a load of 5.0 g was applied using a thermomechanical analyzer (product name; 4000SA commercially available from Bruker), and additionally, the temperature was maintained for 10 minutes, and cooling was then performed at a rate of 5°C/min, and an average coefficient of thermal expansion (coefficient of thermal expansion, CTE) from 250°C to 100°C was obtained.

2) CTE of metal foil

A metal foil having a size of 3 mm×15 mm was subjected to a tensile test in which the temperature was raised or lowered in a temperature range of room temperature to 300°C at a certain temperature rise rate (10°C/min) and temperature decrease rate (10°C/min) while a load of 5.0 g was applied in a thermomechanical analysis (TMA: device name TMA/SS6100) device, and the coefficient of thermal expansion (ppm/K) in the plane direction was measured from the change in the amount of elongation with respect to the temperature change from 100°C to 30°C when the temperature was lowered.

[Measurement of warpage]

For the warpage, a sample having a size of 50 mm×50 mm was left in an atmosphere at 23°C and a humidity of 50% so that the convex surface at the center part of the sample after humidity control for 24 hours was in contact with a flat surface, the distances of raising-up from the static surface of four corners of the sample were measured, and the maximum value thereof was used as an amount of warpage, and if the amount of warpage exceeded 10 mm, it was evaluated as poor, and if the amount of warpage was 10 mm or less, it was evaluated as good.

[Measurement of glass transition temperature (Tg)]

The dynamic viscoelasticity when the polyimide film (10 mm×22.6 mm) was heated from 20°C to 500°C at a rate of 5°C/min with a dynamic thermomechanical analysis device was measured, and the glass transition temperature (Tanδ maximum value: °C) was determined.

[Measurement of thermal decomposition temperature (Td5)]

The change in weight when a polyimide film having a weight of 10 to 20 mg was heated in a nitrogen atmosphere from 30°C to 550°C at a certain rate in a thermogravimetric analysis (TG) device (TG/DTA6200, commercially available from SEIKO) was measured, the weight at 200°C was set to zero, and the temperature when the weight reduction rate was 5% was set as a thermal decomposition temperature (Td5).

[Measurement of surface roughness (Ra and Rz)]

The surface roughness was measured using an AFM (product name: Dimension Icon type SPM commercially available from Bruker AXS), and a probe (commercially available from Bruker AXS, product name: TESPA(NCHV) at a tip curvature radius of 10 nm and a spring constant of 42 N/m) in a tapping mode and in a range of 1 µm×1 µm, and the arithmetic mean roughness (Ra) and the maximum depth (Rz) were determined.

[Measurement of adhesiveness]

During "measurement of warpage," in a procedure of cutting to a predetermined size in order to prepare a sample,

if the polyimide insulation layer and the metal foil were peeled off, the sample was evaluated as poor, and if they were not peeled off, the sample was evaluated as good.

[Measurement of hygroscopicity]

A polyimide film (4 cm×20 cm) was dried at 120°C for 2 hours and then left in a constant temperature and humidity constant machine at 23°C/50% RH for 24 hours, and the change in weight before and after this procedure was determined by the following formula.

Hygroscopicity (wt%)=[(weight after moisture absorption-weight after drying)/ weight after drying]×100

[Measurement of coefficient of hygroscopic expansion (CHE)]

A polyimide film was dried at 120°C for 2 hours and then left in a TMA 4000SA humidity expansion coefficient measurement device (commercially available from BRUKER) in a humidity condition of 23°C/50% RH for 24 hours, and the coefficient of humidity expansion was determined.

[Measurement of tensile elastic modulus]

A tensile test was performed using a tensilon universal test machine (product name; RTA-250 commercially available from Orientec Co., Ltd.) at a tensile speed of 10 mm/min in an environment of a temperature of 23°C and a relative humidity of 50% RH, and the tensile elastic modulus was measured.

[Measurement of water vapor permeability]

Measurement was performed using a gas barrier evaluation test machine (commercially available from Moresco Corporation) according to a WVTR method. The water vapor permeability was measured under conditions of a measurement surface diameter of 60 mm, 40°C, 90% RH, and a test differential pressure of 1 atm. In this case, for detection of permeated water vapor, a gas was detected by a quadrupole mass spectrometer (QMS).

Abbreviations used in examples and the like indicate the following compounds.

PMDA: pyromellitic acid dianhydride
BPDA: 3,3',4,4'-biphenyltetracarboxylic dianhydride
m-TB: 2,2'-dimethyl-4,4'-diaminobiphenyl
BAPP: 2,2-bis[4-(4-aminophenoxy)phenyl]propane
MABA: 4,4'-diamino-2'-methoxybenzanilide
DAPE: 4,4'-diaminodiphenyl ether
TPE-R: 1,3-bis (4-aminophenoxy)benzene
DMAc: N,N-dimethylacetamide

Synthesis Examples 1 to 7

In order to synthesize polyamic acid solutions A to G, under a nitrogen stream, a solvent DMAc was put into a 300 ml separable flask so that the solid content concentration shown in Table 1 was obtained, and diamine components and acid anhydride components shown in Table 1 were dissolved at room temperature with stirring for 10 minutes. Then, the solutions were continuously stirred at room temperature for 10 hours to cause a polymerization reaction, and viscous polyamic acid solutions A to G were prepared.

[Table 1]

| | Synthesis Example | | | | | | |
|---|---|---|---|---|---|---|---|
| | 1 | 2 | 3 | 4 | 5 | 6 | 7 |
| Polyamic acid solution | A | B | C | D | E | F | G |
| m-TB [g] | 19.12 | 9.15 | 21.24 | | 16.57 | | 2.51 |
| TPE-R [g] | 2.92 | | | | 2.53 | | 15.73 |
| MABA [g] | | | | 15.48 | | | |

(continued)

| | Synthesis Example | | | | | | |
|---|---|---|---|---|---|---|---|
| | 1 | 2 | 3 | 4 | 5 | 6 | 7 |
| DAPE [g] | | 7.04 | | 8.01 | | | |
| BAPP [g] | | | 1.27 | | | 23.25 | |
| PMDA [g] | 17.18 | 16.81 | 21.01 | 21.52 | 14.89 | 11.90 | 5.07 |
| BPDA [g] | 5.79 | | 1.49 | | 5.02 | 0.84 | 12.69 |
| DMAc [g] | 255 | 267 | 255 | 255 | 261 | 264 | 264 |
| Total amount [g] | 300 | 300 | 300 | 300 | 300 | 300 | 300 |
| Viscosity [cP] | 17,380 | 2,992 | 7,890 | 255 | 7,260 | 921 | 1,280 |
| Solid content [wt%] | 15 | 11 | 15 | 15 | 13 | 12 | 12 |

[Example 1]

The polyamic acid solution A was uniformly applied to a stainless steel foil 1 (SUS304, thickness; 30 μm, coefficient of thermal expansion; 17 ppm/K, Ra; 5.12 nm, Rz; 43.3 nm) so that the thickness after curing was 4.9 μm, and then heated and dried at 120°C, and the solvent was removed. Next, a stepwise heat treatment was performed from 130°C to 360°C to complete imidization, and thereby a metal-clad laminate 1a was prepared.

The adhesiveness and warpage of the metal-clad laminate 1a were good, and the Ra and Rz of the exposed surface of the polyimide insulation layer that was not in contact with the stainless steel foil 1 were 0.37 nm and 4.4 nm, respectively. The results are shown in Table 2.

In addition, a polyimide film 1a was prepared by etching and removing the stainless steel foil 1 on the metal-clad laminate 1a using a ferric chloride aqueous solution. The CTE of the polyimide film 1a was 5 ppm/K, the Td5 was 517°C, the Tg was 365°C, the CHE was 9 ppm/% RH, and the hygroscopicity was 0.91 wt%. The results are shown in Table 3.

<Evaluation of flexible electronic device >

A thin film transistor was formed on the surface of the polyimide insulation layer in the metal-clad laminate 1a prepared in Example 1, and additionally, an electrode, an organic EL layer and an electrode were sequentially formed thereon, these were hermetically sealed with a glass substrate, and thereby a flexible electronic device 1 was prepared. The flexible electronic device 1 was left in a constant temperature and humidity constant machine at 40°C/90% RH for 1,000 hours, and it was confirmed that the change in the brightness of the flexible electronic device 1 was within 10%.

<Evaluation of heat resistance>

The metal-clad laminate 1a prepared in Example 1 was heated in a nitrogen atmosphere from room temperature to 400°C, and maintained at 400°C for 30 minutes, and then cooled to room temperature. The oxygen concentration when the temperature was maintained at 400°C was 50 ppm or less. The adhesiveness of the metal-clad laminate 1a after heating and cooling was good, and the warpage of the sample obtained by cutting the metal-clad laminate 1a to a size of 5 cm×5 cm was 0.5 mm, which was good.

[Example 2]

A metal-clad laminate 2b and a polyimide film 2b were prepared in the same manner as in Example 1 except that the polyamic acid solution B was used and coating was performed so that the thickness after curing was 5 μm.

The adhesiveness and warpage of the metal-clad laminate 2b were good, and the Ra and Rz of the exposed surface of the polyimide insulation layer that was not in contact with the stainless steel foil 1 were 0.34 nm and 3.2 nm, respectively. The results are shown in Table 2.

In addition, the CTE of the polyimide film 2b was 11.3 ppm/K, the Td5 was 510°C, the Tg was 390°C, the CHE was 14 ppm/% RH, and the hygroscopicity was 1.2 wt%. The results are shown in Table 3.

[Example 3]

A metal-clad laminate 3c and a polyimide film 3c were prepared in the same manner as in Example 1 except that the polyamic acid solution C was used and coating was performed so that the thickness after curing was 5 μm.
The adhesiveness and warpage of the metal-clad laminate 3c were good, and the Ra and Rz of the exposed surface of the polyimide insulation layer that was not in contact with the stainless steel foil 1 were 0.39 nm and 4.5 nm, respectively. The results are shown in Table 2.
In addition, the CTE of the polyimide film 3c was 3 ppm/K, the Td5 was 510°C, the Tg was 310°C, the CHE was 15 ppm/% RH, and the hygroscopicity was 1.3 wt%. The results are shown in Table 3.

[Example 4]

A metal-clad laminate 4d and a polyimide film 4d were prepared in the same manner as in Example 1 except that the polyamic acid solution D was used and coating was performed so that the thickness after curing was 4.9 μm.
The adhesiveness and warpage of the metal-clad laminate 4d were good, and the Ra and Rz of the exposed surface of the polyimide insulation layer that was not in contact with the stainless steel foil 1 were 0.32 nm and 3.1 nm, respectively. The results are shown in Table 2.
In addition, the CTE of the polyimide film 4d was 11.9 ppm/K, the Td5 was 492°C, the Tg was 372°C, the CHE was 26 ppm/% RH, and the hygroscopicity was 1.6 wt%. The results are shown in Table 3.

[Example 5]

A metal-clad laminate 5e and a polyimide film 5e were prepared in the same manner as in Example 1 except that the polyamic acid solution E was used and coating was performed so that the thickness after curing was 3.2 μm.
The adhesiveness and warpage of the metal-clad laminate 5e were good, and the Ra and Rz of the exposed surface of the polyimide insulation layer that was not in contact with the stainless steel foil 1 were 0.5 nm and 5.2 nm, respectively. The results are shown in Table 2.
In addition, the CTE of the polyimide film 5e was 2 ppm/K, the Td5 was 517°C, the Tg was 365°C, the CHE was 9 ppm/% RH, and the hygroscopicity was 0.9 wt%. The results are shown in Table 3.

[Example 6]

A metal-clad laminate 6b and a polyimide film 6b were prepared in the same manner as in Example 1 except that the stainless steel foil 2 (SUS304, thickness; 50 μm, coefficient of thermal expansion; 17 ppm/K, Ra; 9.8 nm, Rz; 72.2 nm) was used in place of the stainless steel foil 1, the polyamic acid solution B was used in place of the polyamic acid solution A, and coating was performed so that the thickness after curing was 6.3 μm.
The adhesiveness and warpage of the metal-clad laminate 6b were good, and the Ra and Rz of the exposed surface of the polyimide insulation layer that was not in contact with the stainless steel foil 2 were 0.34 nm and 4.2 nm, respectively. The results are shown in Table 2.
In addition, the CTE of the polyimide film 6b was 6.1 ppm/K, the Td5 was 510°C, the Tg was 513°C, the CHE was 14 ppm/% RH, and the hygroscopicity was 1.2 wt%. The results are shown in Table 3.

Comparative Example 1

A metal-clad laminate f and a polyimide film f were prepared in the same manner as in Example 1 except that the polyamic acid solution F was used and coating was performed so that the thickness after curing was 5.5 μm.
The adhesiveness of the metal-clad laminate f was good, but the warpage was poor. In addition, the Ra and Rz of the exposed surface of the polyimide insulation layer that was not in contact with the stainless steel foil 1 were 0.5 nm and 4.6 nm, respectively. The results are shown in Table 2.
**In** addition, the CTE of the polyimide film f was 56 ppm/K, the Td5 was 511°C, the Tg was 310°C, the CHE was 7 ppm/% RH, and the hygroscopicity was 0.2 wt%. The results are shown in Table 3.

Comparative Example 2

A metal-clad laminate g and a polyimide film g were prepared in the same manner as in Example 1 except that the polyamic acid solution G was used and coating was performed so that the thickness after curing was 4.7 μm.
The adhesiveness of the metal-clad laminate g was good, but the warpage was poor. In addition, the Ra and Rz of the exposed surface of the polyimide insulation layer that was not in contact with the stainless steel foil 1 were 0.68 nm and

7.8 nm, respectively. The results are shown in Table 2.

In addition, the CTE of the polyimide film g was 51 ppm/K, the Td5 was 511°C, the Tg was 215°C, the CHE was 8 ppm/% RH, and the hygroscopicity was 0.3 wt%. The results are shown in Table 3.

[Table 2]

| | | Metal-clad laminate | | | | | | | | |
|---|---|---|---|---|---|---|---|---|---|---|
| | | Type | Stainless steel foil | | | Polyimide insulation layer | | | Evaluation | |
| | | | Thickness [μm] | Polyimide lamination side | | Thickness [μm] | Surface layer surface side | | Adhesiveness | Warpage |
| | | | | Ra [nm] | Rz [nm] | | Ra [nm] | Rz [nm] | | |
| Example | 1 | 1a | 30 | 5.12 | 43.3 | 4.9 | 0.37 | 4.4 | Good | Good |
| | 2 | 2b | 30 | 5.12 | 43.3 | 5 | 0.34 | 3.2 | Good | Good |
| | 3 | 3c | 30 | 5.12 | 43.3 | 5 | 0.39 | 4.5 | Good | Good |
| | 4 | 4d | 30 | 5.12 | 43.3 | 4.9 | 0.32 | 3.1 | Good | Good |
| | 5 | 5e | 30 | 5.12 | 43.3 | 3.2 | 0.5 | 5.2 | Good | Good |
| | 6 | 6b | 50 | 9.8 | 72.2 | 6.3 | 0.34 | 4.2 | Good | Good |
| Comparative Example | 1 | f | 30 | 5.12 | 43.3 | 5.5 | 0.5 | 4.6 | Good | Poor |
| | 2 | g | 30 | 5.12 | 43.3 | 4.7 | 0.68 | 7.8 | Good | Poor |

[Table 3]

| | | Polyimide film | | | | | | |
|---|---|---|---|---|---|---|---|---|
| | | Type | Thickness [μm] | CTE [ppm/K] | Td5 [°C] | Tg [°C] | CHE [ppm/% RH] | Hygroscopicity [wt%] |
| Example | 1 | 1a | 4.9 | 5 | 517 | 365 | 9 | 0.91 |
| | 2 | 2b | 5 | 11.3 | 510 | 390 | 14 | 1.2 |
| | 3 | 3c | 5 | 3 | 510 | 310 | 15 | 1.3 |
| | 4 | 4d | 4.9 | 11.9 | 492 | 372 | 26 | 1.6 |
| | 5 | 5e | 3.2 | 2 | 517 | 365 | 9 | 0.9 |
| | 6 | 6b | 6.3 | 6.1 | 510 | 513 | 14 | 1.2 |
| Comparative Example | 1 | f | 5.5 | 56 | 511 | 310 | 7 | 0.2 |
| | 2 | g | 4.7 | 51 | 511 | 215 | 8 | 0.3 |

[Example 7]

The polyamic acid solution F was uniformly applied to the stainless steel foil 1 so that the thickness after curing was 1.5 μm, and then heated and dried at 120°C, and the solvent was removed. Next, the polyamic acid solution A was uniformly applied so that the thickness after curing was 3.2 μm, and a stepwise heat treatment was then performed from 130°C to 360°C to complete imidization, and thereby a metal-clad laminate 7 was prepared. The adhesiveness and warpage of the metal-clad laminate 7 were good, and the Ra and Rz of the exposed surface of the polyimide insulation layer that was not in contact with the stainless steel foil 1 were 0.38 nm and 3.2 nm, respectively.

In addition, in the same manner as in Example 1, a polyimide film 7 was prepared by etching and removal. The CTE of the polyimide film 7 was 20 ppm/K, and the CHE was 8 ppm/% RH.

[Example 8]

The polyamic acid solution B was uniformly applied to the stainless steel foil 1 so that the thickness after curing was 2.2 μm, and then heated and dried at 120°C, and the solvent was removed. Next, the polyamic acid solution A was uniformly applied so that the thickness after curing was 3.2 μm, and a stepwise heat treatment was then performed from 130°C to 360°C to complete imidization, and thereby a metal-clad laminate 8 was prepared.
The adhesiveness and warpage of the metal-clad laminate 8 were good, and the Ra and Rz of the exposed surface of the polyimide insulation layer that was not in contact with the stainless steel foil 1 were 0.39 nm and 3.8 nm, respectively.
In addition, a polyimide film 8 was prepared by etching and removal in the same manner as in Example 1. The CTE of the polyimide film 8 was 7 ppm/K, and the CHE was 11 ppm/% RH.

[Example 9]

A metal-clad laminate 9a and a polyimide film 9a were prepared in the same manner as in Example 1 except that the stainless steel foil 3 (SUS444, thickness; 25 μm, coefficient of thermal expansion; 11 ppm/K, tensile elastic modulus; 215 GPa, Ra; 5.58 nm, Rz; 36.4 nm) was used in place of the stainless steel foil 1, and coating was performed so that the thickness after curing the polyamic acid solution A was 6.0 μm.
The adhesiveness and warpage of the metal-clad laminate 9a were good, and the Ra and Rz of the exposed surface of the polyimide insulation layer that was not in contact with the stainless steel foil 3 were 0.31 nm and 3.2 nm, respectively. The results are shown in Table 4.
In addition, the CTE of the polyimide film 9a was -1.6 ppm/K, the Td5 was 517°C, the Tg was 365°C, the CHE was 9 ppm/% RH, the hygroscopicity was 0.91 wt%, and the tensile elastic modulus was 10.5 GPa. The results are shown in Table 5.

[Example 10]

A metal-clad laminate 10b and a polyimide film 10b were prepared in the same manner as in Example 1 except that the stainless steel foil 3 was used in place of the stainless steel foil 1, the polyamic acid solution B was used in place of the polyamic acid solution A, and coating was performed so that the thickness after curing was 6.0 μm.
The adhesiveness and warpage of the metal-clad laminate 10b were good, and the Ra and Rz of the exposed surface of the polyimide insulation layer that was not in contact with the stainless steel foil 3 were 0.25 nm and 2.1 nm, respectively. The results are shown in Table 4.
In addition, the CTE of the polyimide film 10b was 6.4 ppm/K, the Td5 was 510°C, the Tg was 390°C, the CHE was 14 ppm/% RH, the hygroscopicity was 1.2 wt%, and the tensile elastic modulus was 8.5 GPa. The results are shown in Table 5.

[Example 11]

A metal-clad laminate 11a and a polyimide film 11a were prepared in the same manner as in Example 1 except that the titanium foil 1 (TR270C, thickness; 50 μm, coefficient of thermal expansion; 11 ppm/K, tensile elastic modulus; 113 GPa, Ra; 9.71 nm, Rz; 97.5 nm) was used in place of the stainless steel foil 1, and coating was performed so that the thickness after curing the polyamic acid solution A was 6.0 μm.
The adhesiveness and warpage of the metal-clad laminate 11a were good, and the Ra and Rz of the exposed surface of the polyimide insulation layer that was not in contact with the titanium foil 1 were 0.24 nm and 2.5 nm, respectively. The results are shown in Table 4.
In addition, the CTE of the polyimide film 11a was -1.6 ppm/K, the Td5 was 517°C, the Tg was 365°C, the CHE was 9 ppm/% RH, the hygroscopicity was 0.91 wt%, and the tensile elastic modulus was 10.5 GPa. The results are shown in Table 5.

[Example 12]

A metal-clad laminate 12b and a polyimide film 12b were prepared in the same manner as in Example 1 except that the titanium foil 1 was used in place of the stainless steel foil 1, the polyamic acid solution B was used in place of the polyamic acid solution A, and coating was performed so that the thickness after curing was 6.0 μm.
The adhesiveness and warpage of the metal-clad laminate 12b were good, and the Ra and Rz of the exposed surface of the polyimide insulation layer that was not in contact with the titanium foil 1 were 0.28 nm and 3.7 nm, respectively. The results are shown in Table 4.

In addition, the CTE of the polyimide film 12b was 6.4 ppm/K, the Td5 was 510°C, the Tg was 390°C, the CHE was 14 ppm/% RH, the hygroscopicity was 1.2 wt%, and the tensile elastic modulus was 8.5 GPa. The results are shown in Table 5.

[Table 4]

| | | Metal-clad laminate | | | | | | | | |
|---|---|---|---|---|---|---|---|---|---|---|
| | | Type | Stainless steel foil or titanium foil | | | Polyimide insulation layer | | | Evaluation | |
| | | | Thickness [μm] | Polyimide lamination side | | Thickness [μm] | Surface layer surface side | | Adhesiveness | Warpage |
| | | | | Ra [nm] | Rz [nm] | | Ra [nm] | Rz [nm] | | |
| Example | 9 | 9a | 25 | 5.58 | 36.4 | 6 | 0.31 | 3.2 | Good | Good |
| | 10 | 10b | 25 | 5.58 | 36.4 | 6 | 0.25 | 2.1 | Good | Good |
| | 11 | 11a | 50 | 9.71 | 97.5 | 6 | 0.24 | 2.5 | Good | Good |
| | 12 | 12b | 50 | 9.71 | 97.5 | 6 | 0.28 | 3.7 | Good | Good |

[Table 5]

| | | Polyimide film | | | | | | | |
|---|---|---|---|---|---|---|---|---|---|
| | | Type | Thickness [μm] | CTE [ppm/K] | Td5 [°C] | Tg [°C] | CHE [ppm/% RH] | Hygroscopicity [wt%] | Tensile elastic modulus [GPa] |
| Example | 9 | 9a | 6 | -1.6 | 517 | 365 | 9 | 0.91 | 10.5 |
| | 10 | 10b | 6 | 6.4 | 510 | 390 | 14 | 1.2 | 8.5 |
| | 11 | 11a | 6 | -1.6 | 517 | 365 | 9 | 0.91 | 10.5 |
| | 12 | 12b | 6 | 6.4 | 510 | 390 | 14 | 1.2 | 8.5 |

[Example 13]

A metal-clad laminate 13a and a polyimide film 13a were prepared in the same manner as in Example 1 except that coating was performed so that the thickness after curing the polyamic acid solution A was 12.2 μm.

The adhesiveness and warpage of the metal-clad laminate 13a were good, and the Ra and Rz of the exposed surface of the polyimide insulation layer that was not in contact with the stainless steel foil 1 were 0.57 nm and 9.4 nm, respectively.

In addition, the CTE of the polyimide film 13a was 22 ppm/K, the Td5 was 517°C, the Tg was 365°C, the CHE was 9 ppm/% RH, and the hygroscopicity was 0.91 wt%.

<Verification of effect of water vapor barrier property in metal-clad laminate>

(Reference Example 1)

The stainless steel foil 2 was cut to a size of 12 cm×12 cm, a hole was made in the center part by processing with a laser and a stainless steel foil 2' was prepared. The hole size on the surface of the stainless steel foil 2' on the laser inlet side (upper side) had a diameter of 9.1 μm, the hole size on the surface on the laser outlet side (lower side) had a diameter of 32.3 μm, and a conical hole was formed. The water vapor permeability in the stainless steel foil 2' was $6.5\times10^{-3}$ g/($m^2$·day). Here, in the evaluation of the water vapor permeability, water vapor was touched from the upper side of the center part of the stainless steel foil 2'.

(Reference Case Example 1)

The polyamic acid solution A was uniformly applied on the upper side of the stainless steel foil 2' prepared in Reference Example 1 so that the thickness after curing was 5.0 μm, and then heated and dried at 120°C, and the solvent was removed. Next, a stepwise heat treatment was performed from 130°C to 360°C to complete imidization, and thereby a metal-clad laminate 14a' was prepared.

In the metal-clad laminate 14a', water vapor was touched from the side of the polyimide insulation layer under conditions of 40°C and 90% RH, and the water vapor permeability was measured over 4 days, but it was confirmed that the water vapor permeability was less than the measurement lower limit value ($1.0\times10^{-7}$ g/($m^2$·day)), and the effect of the water vapor barrier property by the polyimide insulation layer was strong.

[Example 14]

A metal-clad laminate 14a and a polyimide film 14a were prepared in the same manner as in Example 1 except that the stainless steel foil 2 was used in place of the stainless steel foil 1, and coating was performed so that the thickness after curing the polyamic acid solution A was 5.0 μm.

In the metal-clad laminate 14a, water vapor was touched from the side of the polyimide insulation layer under conditions of 40°C and 90% RH, and the water vapor permeability was measured over 4 days, but it was less than the measurement lower limit value ($1.0\times10^{-7}$ g/($m^2$·day)).

While embodiments of the present invention have been described above in detail for the purpose of illustration, the present invention is not limited to the embodiments.

Priority is claimed on Japanese Patent Application No. 2019-165629, filed September 11, 2019.

[Reference Signs List]

10 Metal layer
20 Polyimide insulation layer
21 Thermoplastic polyimide layer
23 Non-thermoplastic polyimide layer
30 Metal-clad laminate for flexible electronic devices
S Device forming surface

## Claims

1. A metal-clad laminate for flexible electronic devices (30) comprising a metal layer (10) and a polyimide insulation layer (20) comprising a single polyimide layer or a plurality of polyimide layers laminated on one surface of the metal layer (30),

 wherein the polyimide insulation layer (20) satisfies the following conditions (a) to (f);

 (a) the thickness is in a range of 3 μm or more and 25 μm or less;
 (b) a thickness ratio with respect to the metal layer (10) is in a range of 0.1 or more and 0.5 or less;
 (c) the coefficient of thermal expansion is 25 ppm/K or less, wherein a polyimide film having a size of 3 mm×20 mm is heated from 30°C to 250°C at a temperature rise rate of 10°C/min while a load of 5.0 g was applied using a thermomechanical analyzer, and the temperature is maintained for 10 minutes, and cooling is then performed at a rate of 5°C/min, and an average coefficient of thermal expansion from 250°C to 100°C is obtained;
 (d) the coefficient of humidity expansion is 30 ppm/% RH or less, wherein a polyimide film is dried at 120°C for 2 hours and then left in a TMA 4000SA humidity expansion coefficient measurement device in a humidity condition of 23°C/50% RH for 24 hours, and the coefficient of humidity expansion is determined;
 (e) the arithmetic mean roughness (Ra) of an exposed surface that is not in contact with the metal layer is 1.0 nm or less, wherein a surface roughness is measured using an AFM, and a probe in a tapping mode and in a range of 1 μm×1 μm, and the arithmetic mean roughness (Ra) and the maximum depth (Rz) are determined; and
 (f) a polyimide constituting the polyimide layer (23) having an exposed surface is non-thermoplastic, the

exposed surface being not in contact with the metal layer (10), wherein a ratio of a tensile elastic modulus of the polyimide insulation layer (20) to a tensile elastic modulus of the metal layer (10) is in a range of 1/70 or more and 1/10 or less, a tensile test is performed using a tensilon universal test machine at a tensile speed of 10 mm/min in an environment of a temperature of 23°C and a relative humidity of 50% RH, and the tensile elastic modulus is measured, wherein the polyimide contains a diamine residue derived from the diamine compound represented by General Formula (1):

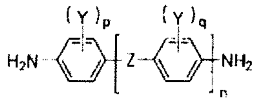

··· (1)

in Formula (1), the linking group Z indicates a single bond, -COO-, or -NHCO-, Y independently indicates a halogen atom, a monovalent hydrocarbon having 1 to 3 carbon atoms or an alkoxy group or alkenyl group having 1 to 3 carbon atoms, which may be substituted with a phenyl group, n indicates an integer of 0 to 2, and p and q independently indicate an integer of 0 to 4.

**2.** The metal-clad laminate for flexible electronic devices (30) according to claim 1, wherein the coefficient of thermal expansion of the metal layer (10) is in a range of 1 ppm/K or more and 25 ppm/K or less.

**3.** The metal-clad laminate for flexible electronic devices (30) according to claim 1, wherein the thickness of the metal layer (10) is in a range of 10 μm or more and 50 μm or less.

**4.** The metal-clad laminate for flexible electronic devices (30) according to claim 1, wherein the polyimide insulation layer (20) is a single layer.

**5.** The metal-clad laminate for flexible electronic devices (30) according to claim 1, wherein the water vapor permeability is $10^{-6}$ g/($m^2$·day) or less.

**6.** The metal-clad laminate for flexible electronic devices (30) according to claim 1,

wherein the laminate is left in an atmosphere at 23°C and a humidity of 50% so that a convex surface at the 50 mm square center part after humidity control for 24 hours is in contact with a flat surface, and when the maximum value of raised-up amounts of four corners is set as an amount of warpage, the amount of warpage is 10 mm or less, for the warpage, a sample having a size of 50 mm×50 mm was left in an atmosphere at 23°C and a humidity of 50% so that the convex surface at the center part of the sample after humidity control for 24 hours is in contact with a flat surface, the distances of raising-up from the static surface of four corners of the sample are measured, and the maximum value thereof is used as the amount of warpage.

**7.** A flexible electronic device, comprising:

the metal-clad laminate for flexible electronic devices (30) according to any one of claims 1 to 6; and
an organic EL layer laminated on an exposed surface of the polyimide insulation layer (20) that is not in contact with the metal layer (10) in the metal-clad laminate for flexible electronic devices (30).

**Patentansprüche**

**1.** Metallkaschiertes Laminat für flexible elektronische Geräte (30), umfassend eine Metallschicht (10) und eine Polyimid-Isolierschicht (20), die eine einzelne Polyimidschicht oder eine Vielzahl von Polyimidschichten umfasst, die auf einer Oberfläche der Metallschicht (10) laminiert sind,

wobei die Polyimid-Isolierschicht (20) die folgenden Bedingungen (a) bis (f) erfüllt:

(a) die Dicke liegt in einem Bereich von 3 μm oder mehr und 25 μm oder weniger;
(b) ein Dickenverhältnis in Bezug auf die Metallschicht (10) liegt in einem Bereich von 0,1 oder mehr und 0,5 oder weniger;

(c) der Wärmeausdehnungskoeffizient beträgt 25 ppm/K oder weniger, wobei ein Polyimidfilm mit einer Größe von 3 mm × 20 mm von 30 °C auf 250 °C mit einer Temperaturanstiegsrate von 10 °C/min erhitzt wird, während eine Last von 5,0 g unter Verwendung eines thermomechanischen Analysators aufgebracht wird, und die Temperatur 10 Minuten lang aufrechterhalten wird, und dann mit einer Rate von 5 °C/min abgekühlt wird, und ein durchschnittlicher Wärmeausdehnungskoeffizient von 250 °C bis 100 °C erhalten wird;
(d) der Feuchtigkeitsausdehnungskoeffizient beträgt 30 ppm/% RH oder weniger, wobei ein Polyimidfilm 2 Stunden bei 120 °C getrocknet und dann 24 Stunden in einem TMA 4000SA-Feuchtigkeitsausdehnungskoeffizienten-Messgerät bei einer Feuchtigkeit von 23 °C/50 % RH belassen wird und der Feuchtigkeitsausdehnungskoeffizient bestimmt wird;
(e) die arithmetische mittlere Rauheit (Ra) einer freiliegenden Oberfläche, die nicht mit der Metallschicht in Kontakt steht, beträgt 1,0 nm oder weniger, wobei eine Oberflächenrauheit unter Verwendung eines AFM mit einer Sonde in einem Tapping-Modus in einem Bereich von 1 μm × 1 μm gemessen wird und die arithmetische mittlere Rauheit (Ra) und die maximale Tiefe (Rz) bestimmt werden; und
(f) ein Polyimid, das die Polyimidschicht (23) mit einer freiliegenden Oberfläche bildet, nicht thermoplastisch ist, wobei die freiliegende Oberfläche nicht mit der Metallschicht (10) in Kontakt steht,

wobei ein Verhältnis eines Zugelastizitätsmoduls der Polyimid-Isolierschicht (20) zu einem Zugelastizitätsmodul der Metallschicht (10) in einem Bereich von 1/70 oder mehr und 1/10 oder weniger liegt, ein Zugversuch unter Verwendung einer Tensilon-Universalprüfmaschine bei einer Zuggeschwindigkeit von 10 mm/min in einer Umgebung mit einer Temperatur von 23 °C und einer relativen Luftfeuchtigkeit von 50 % RH durchgeführt wird und der Zugelastizitätsmodul gemessen wird,
wobei das Polyimid einen Diaminrest enthält, der von der durch die allgemeine Formel (1) dargestellten Diaminverbindung abgeleitet ist:

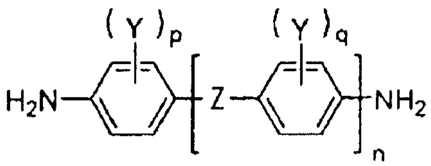
··· (1)

wobei in Formel (1) die Verknüpfungsgruppe Z für eine Einfachbindung, -COO- oder -NHCO- steht, Y unabhängig für ein Halogenatom steht, einen einwertigen Kohlenwasserstoff mit 1 bis 3 Kohlenstoffatomen oder eine Alkoxygruppe oder Alkenylgruppe mit 1 bis 3 Kohlenstoffatomen, die mit einer Phenylgruppe substituiert sein kann, n für eine ganze Zahl von 0 bis 2 steht und p und q unabhängig voneinander für eine ganze Zahl von 0 bis 4 stehen.

**2.** Metallkaschiertes Laminat für flexible elektronische Geräte (30) nach Anspruch 1, wobei der Wärmeausdehnungskoeffizient der Metallschicht (10) in einem Bereich von 1 ppm/K oder mehr und 25 ppm/K oder weniger liegt.

**3.** Metallkaschiertes Laminat für flexible elektronische Geräte (30) nach Anspruch 1, wobei die Dicke der Metallschicht (10) in einem Bereich von 10 μm oder mehr und 50 μm oder weniger liegt.

**4.** Metallkaschiertes Laminat für flexible elektronische Geräte (30) nach Anspruch 1, wobei die Polyimid-Isolierschicht (20) eine einzelne Schicht ist.

**5.** Metallkaschiertes Laminat für flexible elektronische Geräte (30) nach Anspruch 1, wobei die Wasserdampfdurchlässigkeit $10^{-6}$ g/($m^2$·Tag) oder weniger beträgt.

**6.** Metallkaschiertes Laminat für flexible elektronische Geräte (30) nach Anspruch 1,

wobei das Laminat in einer Atmosphäre bei 23 °C und einer Luftfeuchtigkeit von 50 % so belassen wird, dass eine konvexe Oberfläche in dem Mittelpunkt eines 50 mm × 50 mm großen Bereichs nach einer 24-stündigen Feuchtigkeitskonditionierung mit einer ebenen Oberfläche in Kontakt steht, und wenn der Maximalwert der Anhebungsbeträge der vier Ecken als Verzugsbetrag festgelegt wird, der Verzugsbetrag 10 mm oder weniger beträgt,
wobei für den Verzug eine Probe mit einer Größe von 50 mm × 50 mm in einer Atmosphäre bei 23 °C und einer Luftfeuchtigkeit von 50 % belassen wurde, sodass die konvexe Oberfläche in dem Mittelpunkt der Probe nach

einer 24-stündigen Feuchtigkeitskonditionierung mit einer ebenen Oberfläche in Kontakt steht, die Abstände der Anhebung der vier Ecken der Probe von der festen Oberfläche gemessen und deren Maximalwert als Verzugsbetrag verwendet werden.

**7.** Flexibles elektronisches Gerät, umfassend:

das metallkaschierte Laminat für flexible elektronische Geräte (30) nach einem der Ansprüche 1 bis 6; und eine organische EL-Schicht, die auf einer freiliegenden Oberfläche der Polyimid-Isolierschicht (20) laminiert ist, die nicht mit der Metallschicht (10) in dem metallkaschierten Laminat für flexible elektronische Geräte (30) in Kontakt steht.

## Revendications

**1.** Stratifié revêtu de métal pour dispositifs électroniques flexibles (30) comprenant une couche métallique (10) et une couche isolante en polyimide (20) comprenant une seule couche de polyimide ou une pluralité de couches de polyimide stratifiées sur une surface de la couche métallique (30), dans lequel la couche isolante en polyimide (20) satisfait aux conditions (a) à (f) suivantes :

(a) l'épaisseur est comprise de 3 μm ou plus et de 25 μm ou moins;
(b) le rapport d'épaisseur par rapport à la couche métallique (10) est compris de 0,1 ou plus et de 0,5 ou moins;
(c) le coefficient de dilatation thermique est inférieur ou égal à 25 ppm/K, dans lequel un film de polyimide d'une taille de 3 mm × 20 mm est chauffé de 30 °C à 250 °C à une vitesse d'augmentation de température de 10 °C/min tout en appliquant une charge de 5,0 g à l'aide d'un analyseur thermomécanique, la température est maintenue pendant 10 minutes, puis le refroidissement est effectué à une vitesse de 5 °C/min, et un coefficient moyen de dilatation thermique de 250 °C à 100 °C est obtenu ;
(d) le coefficient de dilatation hygrométrique est inférieur ou égal à 30 ppm/% HR, dans lequel un film de polyimide est séché à 120 °C pendant 2 heures, puis laissé dans un dispositif de mesure du coefficient de dilatation hygrométrique TMA 4000SA dans des conditions d'humidité de 23 °C/50 % HR pendant 24 heures, et le coefficient de dilatation hygrométrique est déterminé ;
(e) la rugosité moyenne arithmétique (Ra) d'une surface exposée qui n'est pas en contact avec la couche métallique est inférieure ou égale à 1,0 nm, dans lequel une rugosité de surface est mesurée à l'aide d'un AFM et d'une sonde en mode tapping et dans une plage de 1 μm × 1 μm, et la rugosité moyenne arithmétique (Ra) et la profondeur maximale (Rz) sont déterminées ; et
(f) un polyimide constituant la couche de polyimide (23) ayant une surface exposée n'est pas thermoplastique, la surface exposée n'étant pas en contact avec la couche métallique (10),

dans lequel le rapport entre le module d'élasticité en traction de la couche isolante en polyimide (20) et le module d'élasticité en traction de la couche métallique (10) est compris dans une plage de 1/70 ou plus et 1/10 ou moins, un essai de traction est effectué à l'aide d'une machine d'essai universelle Tensilon à une vitesse de traction de 10 mm/min dans un environnement à une température de 23 °C et à une humidité relative de 50 % HR, et le module d'élasticité en traction est mesuré,
dans lequel le polyimide contient un résidu diamine dérivé du composé diamine représentée par la formule générale (1) :

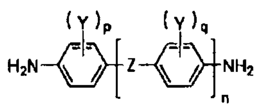

··· (1)

dans la formule (1), le groupe de liaison Z indique une liaison simple, -COO- ou - NHCO-, Y indique indépendamment un atome d'halogène, un hydrocarbure monovalent ayant 1 à 3 atomes de carbone ou un groupe alcoxy ou alcényle ayant 1 à 3 atomes de carbone, qui peut être substitué par un groupe phényle, n indique un nombre entier de 0 à 2, et p et q indiquent indépendamment un nombre entier de 0 à 4.

**2.** Stratifié revêtu de métal pour dispositifs électroniques flexibles (30) selon la revendication 1, dans lequel le coefficient de dilatation thermique de la couche métallique (10) est compris entre 1 ppm/K et 25 ppm/K.

**3.** Stratifié revêtu de métal pour dispositifs électroniques flexibles (30) selon la revendication 1, dans lequel l'épaisseur

de la couche métallique (10) est comprise de 10 μm ou plus et 50 μm ou moins.

4. Stratifié revêtu de métal pour dispositifs électroniques flexibles (30) selon la revendication 1, dans lequel la couche isolante en polyimide (20) est une couche unique.

5. Stratifié revêtu de métal pour dispositifs électroniques flexibles (30) selon la revendication 1, dans lequel la perméabilité à la vapeur d'eau est inférieure ou égale à $10^{-6}$ g/($m^2$×jour).

6. Stratifié revêtu de métal pour dispositifs électroniques flexibles (30) selon la revendication 1,

   dans lequel le stratifié est laissé dans une atmosphère à 23 °C et à une humidité de 50 % de sorte qu'une surface convexe au centre d'une partie carrée de 50 mm après contrôle de l'humidité pendant 24 heures soit en contact avec une surface plane, et lorsque la valeur maximale des quantités soulevées des quatre coins est définie comme une quantité de gauchissement, la quantité de gauchissement est inférieure ou égale à 10 mm,
   pour le gauchissement, un échantillon d'une taille de 50 mm × 50 mm a été laissé dans une atmosphère à 23 °C et à une humidité de 50 % de manière à ce que la surface convexe au centre de l'échantillon après un contrôle de l'humidité pendant 24 heures soit en contact avec une surface plane, les distances de soulèvement par rapport à la surface statique des quatre coins de l'échantillon sont mesurées, et la valeur maximale de celles-ci est utilisée comme valeur de gauchissement.

7. Dispositif électronique flexible, comprenant :

   le stratifié revêtu de métal pour dispositifs électroniques flexibles (30) selon l'une quelconque des revendications 1 à 6 ; et
   une couche EL organique stratifiée sur une surface exposée de la couche isolante en polyimide (20) qui n'est pas en contact avec la couche métallique (10) dans le stratifié revêtu de métal pour dispositifs électroniques flexibles (30).

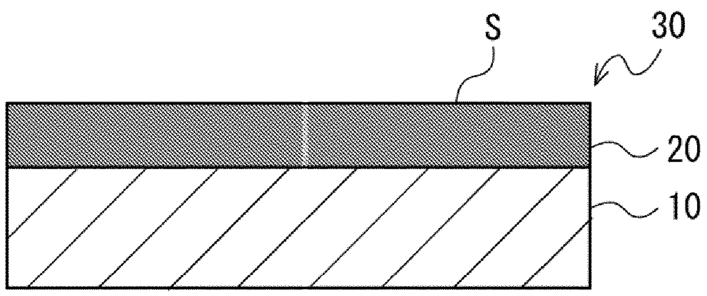


FIG. 1

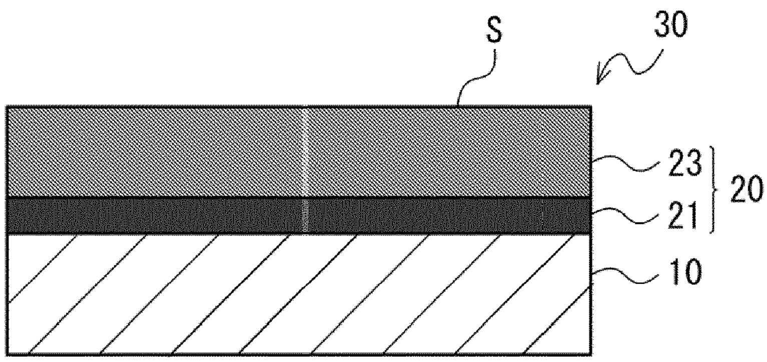


FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2013087310 A
- JP 2017073345 A
- JP 2019165629 A